# EUROPÄISCHE PATENTSCHRIFT

(11) **EP 2 329 528 B1**
(45) Veröffentlichungstag und Bekanntmachung des Hinweises auf die Patenterteilung: **12.10.2016**
(21) Anmeldenummer: 09777839.3
(22) Anmeldetag: 12.08.2009
(51) Int. Cl.: H01L 31/0747, H01L 31/0216, H01L 31/18

(54) **HETEROSOLARZELLE UND VERFAHREN ZU DEREN HERSTELLUNG**
HETEROSTRUCTURE SOLAR CELL AND METHOD FOR ITS FABRICATION
CELLULE SOLAIRE À HÉTÉROJONCTION ET SON PROCÉDÉ DE FABRICATION

(30) Priorität: 03.09.2008 DE 102008045522
(43) Veröffentlichungstag der Anmeldung: 08.06.2011
(73) Patentinhaber: Fraunhofer-Gesellschaft zur Förderung der angewandten Forschung e.V., 80686 München (DE)
(72) Erfinder: PYSCH, Damian, 79115 Freiburg (DE); GLUNZ, Stefan, 79111 Freiburg (DE)
(86) Internationale Anmeldenummer: PCT/EP2009/005855
(87) Internationale Veröffentlichungsnummer: WO 2010/025809

(56) Entgegenhaltungen:
- WO-A2-2006/128427
- WO-A2-2009/094578
- US-A1- 2002 069 911
- US-A1- 2007 256 728
- GUDOVSKIKH A S ET AL: "Investigation of a-Si:H/c-Si heterojunction solar cells interface properties" THIN SOLID FILMS, ELSEVIER-SEQUOIA S.A. LAUSANNE, CH LNKD- DOI:10.1016/J.TSF.2003.10.127, Bd. 451-452, 22. März 2004 (2004-03-22), Seiten 345-349, XP004495124 ISSN: 0040-6090
- SCHMIDT M ET AL: "Physical aspects of a-Si:H/c-Si hetero-junction solar cells" THIN SOLID FILMS, ELSEVIER-SEQUOIA S.A. LAUSANNE, CH LNKD- DOI:10.1016/J.TSF.2006.11.087, Bd. 515, Nr. 19, 16. Juli 2007 (2007-07-16), Seiten 7475-7480, XP022820256 ISSN: 0040-6090 [gefunden am 2007-08-07] in der Anmeldung erwähnt
- TAGUCHI M ET AL: "Obtaining a higher Voc in HIT cells" PROGRESS IN PHOTOVOLTAICS: RESEARCH AND APPLICATIONS WILEY UK, Bd. 13, Nr. 6, September 2005 (2005-09), Seiten 481-488, XP002595700 ISSN: 1062-7995
- DE WOLF STEFAAN ET AL: "Boron-doped a-Si:Hâ c-Si interface passivation: Degradation mechanism" APPLIED PHYSICS LETTERS, AIP, AMERICAN INSTITUTE OF PHYSICS, MELVILLE, NY, US LNKD- DOI:10.1063/1.2783972, Bd. 91, Nr. 11, 12. September 2007 (2007-09-12), Seiten 112109-112109, XP012099146 ISSN: 0003-6951
- FUJIWARA HIROYUKI ET AL: "Impact of epitaxial growth at the heterointerface of a-Si:H/c-Si solar cells" APPLIED PHYSICS LETTERS, AIP, AMERICAN INSTITUTE OF PHYSICS, MELVILLE, NY, US LNKD- DOI:10.1063/1.2426900, Bd. 90, Nr. 1, 2. Januar 2007 (2007-01-02) , Seiten 13503-1-13503-3, XP012093394 ISSN: 0003-6951
- CLAUDIO G ET AL: 'AMORPHOUS CRYSTALLINE SILICON HETEROJUNCTION WITH SILICON NITRIDE BUFFER LAYER' AMORPHOUS AND HETEROGENEOUS SILICON THIN FILMS - 2000. SAN FRANCISCO, CA, APRIL 24 - 28, 2000; [MATERIALS RESEARCH SOCIETY SYMPOSIUM PROCEEDINGS. VOL. 609. (MRS)], WARRENDALE, PA : MRS, US Bd. 609, 24 April 2000, Seiten A13.4.01 - A13.4.06, XP001134723 ISBN: 978-1-55899-517-8

## Beschreibung

Die Erfindung betrifft eine Heterosolarzelle wie in Anspruch 1 angegeben, die Silizium, dotierte Siliziumschichten und Tunnelpassivierungsschichten enthält. Diese ist durch eine Indium-Zinn-Oxid Schicht auf der Vorderseite und durch eine Aluminiumschicht auf der Rückseite abgeschlossen. Weiterhin umfasst die Erfindung ein Verfahren zur Herstellung von Heterosolarzellen, wie in Anspruch 16 angegeben.

Wafer-basierte kristalline Silizium-Solarzellen mit einem Emitter aus amorphem Silizium (Heterosolarzellen) sind auf dem Markt erhältlich. Als Ausgangsmaterial wird dazu monokristallines Silizium eingesetzt, das n- oder p-dotiert ist (M. Tanaka, et al., Jnp. J. Appl. Phys., Vol. 31, (1992), S. 3518-3522 und M. Schmidt, et al., Thin Solid Films 515 (2007), S. 7475). Auf dieses wird zur beleuchteten Seite zuerst eine sehr dünne (ca. 1 bis 10 nm) intrinsische (undotierte) amorphe Siliziumschicht aufgetragen. Danach folgt die Auftragung einer ebenfalls sehr dünnen (ca. 1 bis 10 nm), dotierten, amorphen Siliziumschicht, deren Dotierung der Basisdotierung entgegengesetzt ist. Abschließend wird ein leitfähiges transparentes Oxid, wie-z.B. Indium-Zinn-Oxid (ITO) und dünne Metallkontakte aufgetragen. Auf der unbeleuchteten Rückseite des kristallinen Wafers wird zuerst eine sehr dünne (ca. 1 bis 10 nm), intrinsische (undotierte), amorphe Siliziumschicht und im Anschluss eine sehr dünne (ca. 1 bis 10 nm), dotierte, amorphe Siliziumschicht, die der Basisdotierung angepasst ist, aufgetragen. Abschließend wird eine Metallschicht aufgetragen, die der Kontaktierung der Solarzelle dient.

Die amorphen Siliziumschichten werden gegenwärtig mittels Plasma-unterstützter Gasphasenabscheidung (PECVD-Technologie) und das leitfähige transparente Oxid (ITO) mittels Sputter-Technologie hergestellt.

Der Wirkungsgrad der Hetero-Siliziumsolarzelle reagiert sehr sensitiv auf die Defektzustandsdichte der Grenzfläche zwischen kristallinem Silizium und dem amorphen Emitter (bzw. intrinsischer, amorpher Siliziumschicht). Die geringe Defektdichte der Grenzfläche wird zurzeit hauptsächlich durch eine geeignete Vorbehandlung des kristallinen Wafers (z.B. nasschemisch, wie bei H. Angermann, et al., Material Science and Engineering B, Vol. 73, (2000), S. 178) und durch die intrinsische bzw. dotierte amorphe Siliziumschicht selbst realisiert.

Eine weitere Möglichkeit eine Grenzfläche zu passivieren, kann durch das Platzieren von ortsfesten Ladungen möglichst nahe an der zu passivierenden Grenzschicht erreicht werden (A. Aberle, et al., J. Appl. Phys. 71(9), (1992), S. 4422). Diese Möglichkeit wird bei den gegenwärtigen Silizium-Heterosolarzellenstrukturen nicht gezielt genutzt.

Ein weiteres aus dem Stand der Technik bekanntes Verfahren zur Herstellung von Heterosolarzellen ist die Abscheidung der amorphen Schichten mittels PECVD. Sobald die Oberfläche keine einheitliche Topographie aufweist, wird auf den Spitzen und in den Tälern der Texturpyramiden unterschiedlich viel der zu deponierenden Substanz abgeschieden. Dies erfordert eine Vorbehandlung der Texturpyramiden (M. Tanaka, et al., Jnp. J. Appl. Phys., Vol. 31, (1992), S. 3518-3522).

A.S. Gudovskikh et al. beschreiben in "Thin Solid Films, 451-452 (2004) 345-349 Heterosolarzellen, bei denen eine Schicht aus einer n-dotierten amorphen Siliziumschicht auf einem kristallinen p-dotierten Si-Substrat aufgebracht ist. Vor der Aufschichtung der amorphen Schicht wird der Si-Wafer z.B. mit einer ultradünnen Oxidschicht beschichtet. Auf die amorphe Siliziumschicht kann weiter eine leitfähige Schicht aus ZnO(Al) aufgebracht werden.

Aus der WO 2009/094578 sind verschiedene Schichtaufbauten von Solarzellen bekannt. Ein beispielhafter Schichtaufbau beruht dabei auf einem Emitter, der aus einer a-Si(i)-Schicht sowie einer a-Si(p)-Schicht aufgebaut ist. Zwischen Emitter und Wafer weist die Solarzelle eine SiO₂-Schich auf.

Ausgehend hiervon ist es Aufgabe der vorliegenden Erfindung, die Nachteile des Standes der Technik zu beseitigen und Heterosolarzellen bereitzustellen, die wesentlich robuster bezüglich hoher Grenzflächendefektdichte und Kurzschlüssen an den Texturpyramidenspitzen sind und eine schnellere Prozessierungermöglichen.

Diese Aufgabe wird durch die Heterosolarzelle mit den Merkmalen des Anspruchs 1 gelöst. Anspruch 16 betrifft ein Verfahren zur Herstellung von Heterosolarzellen. Weitere vorteilhafte Ausführungsformen sind in den abhängigen Ansprüchen enthalten.

Erfindungsgemäß wird eine Heterosolarzelle bereitgestellt, die eine auf der vorderseitigen Oberfläche eines kristallinen, dotierten Silizium-Wafers (c-Si-Schicht) angeordneten Emitter aus einer amorphen, der c-Si-Schicht entgegengesetzt dotierten, Silizium-Schicht (a-Si-Schicht) sowie einer darauf angeordneten ITO-Schicht (Indium-Zinn-Oxid-Schicht) mit Vorderseitenkontakt und einer auf der rückseitigen Oberfläche angeordneten Metallisierungsschicht umfasst, wobei mindestens zwischen der vorderseitigen Oberfläche der c-Si-Schicht und der Emitter-Schicht eine Tunnelpassivierungsschicht aufgebracht ist, und wobei die Tunnelpassivierungsschicht Aluminiumoxid enthält. Durch diesen Aufbau wird das Erreichen hoher Wirkungsgrad wesentlich robuster. Dieser ist dabei von der Schichtdicke wie auch der Gleichmäßigkeit der Schichten abhängig.

Die Dicke der Tunnelpassivierungsschicht ist bevorzugt so gewählt, dass ein quantenmechanischer Tunnelstrom fließt. Dies gilt insbesondere für Passivierungsschichten mit einer Bandlücke E_{g} ≥ 2 eV.

Die Heterosolarzelle kann auf der vorderseitigen und rückseitigen Oberfläche eine Tunnelpassivierungsschicht aufweisen.

Durch den Einsatz der Tunnelpassivierungsschichten treten die bisher üblichen, aufwändigen Vorreinigungsverfahren der Wafer in den Hintergrund. Gegebenenfalls können sie sogar vollständig entfallen und so eine schnellere Herstellung von Heterosolarzellen ermöglichen, die zusätzlich kostengünstiger ist.

Die Tunnelpassivierungsschicht der Heterosolarzelle enthält erfindungsgemäß Aluminiumoxid . Bevorzugt wird dabei eine Tunnelpassivierungsschicht aus Aluminiumoxid Al₂O₃, da dieses Material mehrere Vorzüge aufweist. Die Aluminiumoxidschichten besitzen eine sehr hohe Dichte an eingebauten, negativen Ladungen, daher ergibt sich eine außerordentlich gute Passivierqualität. Darüber hinaus kann Aluminiumoxid mittels der Atomlagenabscheidungsmethode oder ähnlich arbeitenden PECVD-Verfahren auf nahezu jeder Oberflächentopographie homogen deponiert werden. Hierbei ist die Wachstumsrate auf senkrechten Flanken gleich der Wachstumsrate auf ebenen Bereichen. In die Tunnelpassivierungsschicht können nachträglich feste Ladungen (z.B. durch Ionenimplantation von Cs⁺-Ionen) eingebaut werden.

In einer bevorzugten Ausführungsform liegt die Dicke der Tunnelpassivierungsschicht aus Aluminiumoxid zwischen 0,1 und 10 nm, da diese Schichtdicke sowohl ein quantenmechanisches Tunneln der Ladungsträger als auch die Passivierung der Oberflächen ermöglicht.

In der erfindungsgemäßen Heterosolarzelle wird die Aluminiumoxid-Schicht Al₂O₃ (bzw. andere Aluminiumoxid-Stöchiometrien) mit anschließendem Einbau von festen Ladungen (z-. B-. durch Ionenimplantation von Cs⁺-Ionen ) sowohl direkt auf die vorgereinigte (gegebenenfalls abgeschwächt vorgereinigte beziehungsweise unbehandelte) und texturierte Vorderseite als auch auf die reflexoptimierte Rückseitenoberfläche abgeschieden. Die eingebauten negativen Ladungen der Aluminiumoxidschicht verstärken dabei den Passivierungseffekt deutlich. Da Aluminiumoxid eine höhere Bandlücke als kristallines und amorphes Silizium besitzt, muss dessen Schichtdicke einerseits möglichst klein gewählt werden, um ein quantenmechanisches Tunneln der Ladungsträger durch diese Schicht zu ermöglichen und andererseits eine ausreichende Dicke aufweisen, so dass die Passivierungswirkung gewährleistet ist. Um beide Anforderungen zu erfüllen, ist es günstig eine Schichtdicke im ein- bis zweistelligen Ångströmbereich einzuhalten. Da die Schichtdicke z.B. durch den Einsatz der Atomlagendepositions-Technologie (ALD) (bzw. ähnlich arbeitenden PECVD-Verfahren) sehr präzise eingestellt werden kann, ist eine hohe Reproduzierbarkeit gewährleistet. Diese Schicht kann entweder zusätzlich in das System eingebaut werden oder die intrinsische, amorphe Schicht ersetzen. Durch den Einsatz der ALD-Technologie (bzw. ähnlich arbeitenden PECVD-Verfahren) ist auch gleichzeitig eine gleichmäßige Bedeckung der Texturpyramiden garantiert.

Die wesentlichen Vorteile der Heterosolarzelle sowie des Herstellungsverfahrens durch den Einsatz von dünnen Tunnel-Passivierungsschichten die Aluminiumoxid enthalten sind:
◆ eine homogene Bedeckung der Texturpyramiden
◆ die Anforderungen an die Vorreinigung des kristallinen Wafers können stark reduziert werden oder gegebenenfalls vollständig entfallen
◆ die Forderung nach einer möglichst sanften Plasmaabscheidung kann gegebenenfalls gelockert werden (z.B. Al₂O₃ sorgt für die Passivierwirkung). Dadurch können höhere Aufwachsraten eingesetzt werden, die eine schnellere Prozessierung zur Folge haben
◆ ein insgesamt wesentlich robusteres Verfahren

Zusätzlich es ist gegebenenfalls möglich, auf die undotierte (intrinsische) amorphe Schicht zu verzichten und somit eine Verkürzung und Vereinfachung des Herstellungsprozesses zu erreichen.

Somit kann insgesamt durch den beschriebenen Einsatz von Tunnel-Schichten der Wirkungsgrad von n- und/oder p-Typ (Basiswafer)-Heterosolarzellen gesteigert werden.

Bevorzugt besteht die Emitter-Schicht aus einer, der c-Si-Schicht entgegengesetzt dotierten, a-Si-Schicht und einer intrinsischen Silizium-Schicht (i-Si-Schicht).

Die Dicke der, der c-Si-Schicht entgegengesetzt dotierten, a-Si-Schicht liegt vorzugsweise zwischen 1 und 10 nm. So wird gewährleistet, dass die Schicht homogen ist. Zusätzlich ermöglicht diese Schichtdicke den Aufbau einer Heterosolarzelle.

In einer Variante der Heterosolarzelle liegt die gewählte Dicke der i-Si-Schicht zwischen 1 und 10 nm. Die Schichtdicke der undotierten i-Si-Schicht wird somit möglichst gering gehalten.

Die intrinsische wie auch die amorphe Siliziumschicht können ferner auch der Passivierung dienen

Bevorzugt wird wischen der rückseitigen Oberfläche und der Metallisierungsschicht eine, der c-Si-Schicht gleich dotierte, amorphe Siliziumschicht aufgebracht.

Die Dicke dieser amorphen Siliziumschicht liegt in einer alternativen Ausführung der Heterosolarzelle zwischen 1 und 30 nm.

In einer weiteren Ausführungsform wird zwischen der Metallisierungsschicht und der auf der rückseitigen Oberfläche aufgebrachten, der kristallinen Siliziumschicht gleich dotierten, amorphen Siliziumschicht eine intrinsische Siliziumschicht aufgebracht.

Die Dicke der intrinsischen Siliziumschicht liegt bevorzugt zwischen 1 und 10 nm.

Die kristalline Siliziumschicht ist bevorzugt n- oder p-dotiert. Die Dicke dieser Schicht liegt vorzugsweise zwischen 20 und 2000 µm.

In einer weiteren Ausführungsform der Heterosolarzelle ist die in der Emitter-Schicht enthaltene, der c-Si-Schicht entgegengesetzt dotierte, amorphe Siliziumschicht n- oder p-dotiert.

Die zwischen der rückseitigen Oberfläche und der Metallisierungsschicht aufgebrachte, der kristallinen Siliziumschicht gleich dotierte, amorphe Siliziumschicht kann n- oder p-dotiert sein.

Weiterhin umfasst die Erfindung ein Verfahren zur Herstellung der bereits beschriebenen Heterosolarzelle.

Dabei ist die mindestens eine Tunnelpassivierungsschicht bevorzugt mittels Atomlagendepositions- oder PECVD-Technologie abgeschieden worden. Dieses Verfahren der Atomlagendeposition (bzw. ähnlich arbeitender PECVD-Verfahren) bewirkt eine homogene Bedeckung der Texturpyramiden und verringert die Anforderungen an die Vorreinigung des kristallinen Wafers bzw. macht diese überflüssig.

Die Tunnelpassivierungsschicht besteht erfindungsgemäß aus Aluminiumoxid oder enthält dieses. Sie kann auch Cs⁺-Ionen enthalten. In die Tunnelpassivierungsschicht können anschließend feste Ladungen (z.B. durch Ionenimplantation von Cs⁺-Ionen) eingebaut werden. Derartige Schichten ermöglichen das quantenmechanische Tunneln der Ladungsträger durch diese, wie auch eine Passivierung. Da die Atom-lagendepositions-Technologie bzw. das ähnlich arbeitende PECVD-Verfahren sehr präzise eingestellt werden können, kann eine exakte Abscheidung der Schichten gewährleistet werden. Zusätzlich kann die Forderung nach einer sanften Plasmaabscheidung der amorphen Siliziumschichten gelockert werden, da diese Tunnel-schichten für die Passivierungswirkung sorgen. Dadurch können höhere Aufwachsraten eingesetzt werden und eine schnellere Prozessierung wird so ermöglicht.

Das erfindungsgemäße Verfahren ist dadurch gekennzeichnet, dass die mindestens eine Tunnelpassivierungsschicht Aluminiumoxid enthält oder aus diesem besteht. Das Aluminiumoxid kann hierbei auch andere Stöchiometrien als Al₂O₃ aufweisen. Weiterhin können feste Ladungen eingebaut werden (z.B. durch Ionenimplantation von Cs⁺-Ionen).

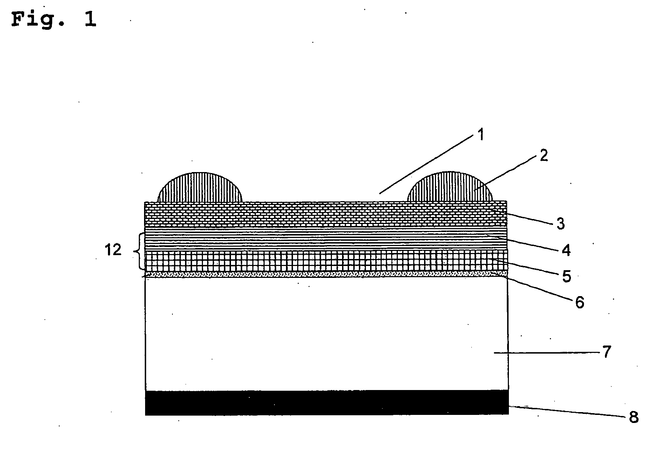

Anhand der folgenden Figuren 1 bis 3 soll der anmeldungsgemäße Gegenstand näher erläutert werden, ohne diesen auf die hier gezeigten speziellen Ausführungsformen einschränken zu wollen. Der erfindungsgemäße Gegenstand wie auch das Verfahren gelten für beliebige Oberflächen des kristallinen Wafers (bevorzugt Texturpyramiden).
- Figur 1: zeigt den Aufbau einer Heterosolarzelle mit einer vorderseitigen Tunnelpassivierungsschicht und Emitterschicht;
- Figur 2: zeigt den Aufbau einer Heterosolarzelle mit einer vorderseitigen Tunnelpassivierungsschicht und Emitterschicht und zusätzlicher Rückseitenbeschichtung inklusive Tunnelpassivierungsschicht;
- Figur 3: zeigt den Aufbau einer Heterosolarzelle mit einer vorderseitigen Tunnelpassivierungsschicht und Emitterschicht und einer zusätzlichen Rückseitenbeschichtung inklusive Tunnelpassivierungsschicht, die eine weitere intrinsische Schicht enthält.

In Figur 1 ist eine Ausführungsform der Heterosolarzelle 1 dargestellt, bei der auf der kristallinen vorderseitigen Oberfläche des Si-Wafers 7 eine Emitter-Schicht 12 angeordnet ist. Die kristalline Siliziumschicht 7 ist n-dotiert und weist eine Dicke von ca. 200 µm auf. Mittels Atomlagendeposition wird die Tunnelpassivierungsschicht (z.B. Aluminiumoxid-schicht (Al₂O₃) 6, die eine Dicke von 0,1 bis 10 nm aufweist, mittels ALD bzw. PECVD abgeschieden. Im Anschluss wird die intrinsische amorphe Siliziumschicht 5, die nicht dotiert ist, aufgetragen. Diese weist eine Dicke von 1 bis 10 nm auf. Die p-dotierte amorphe Siliziumschicht 4, die der Vorderseite bzw. der bestrahlten Seite zugewandt ist, weist eine Dicke von 1 bis 10 nm auf. Die Schichten 4 und 5 bilden dabei die Emitter-Schicht 12. Darauf wird eine leitfähige transparente Oxidschicht (ITO) 3 mittels Sputter-Technologie und einer Schichtdicke von ca. 80 nm aufgetragen (abhängig vom Brechungsindex des ITO). Auf der Rückseite der Heterosolarzelle ist eine Aluminiumschicht 8 aufgetragen. Diese dient, wie auch die Vorderseitenkontakte 2 der Heterosolarzelle, der Kontaktierung.

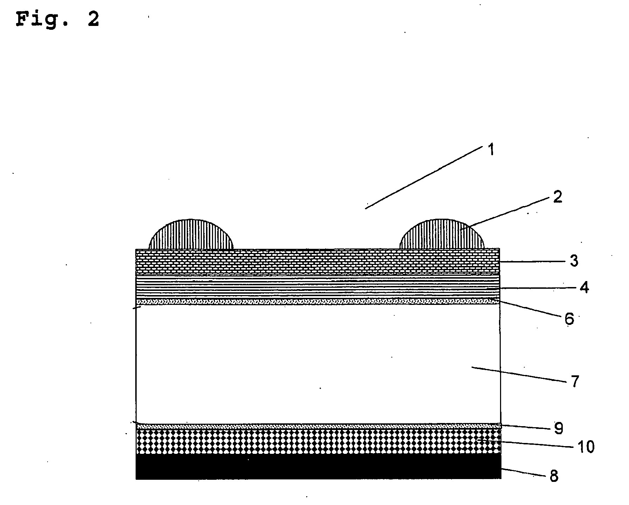

Figur 2 zeigt den Schichtaufbau einer planen Silizium-Heterosolarzelle 1 mit einer vorderseitigen Emitterschicht und einer zusätzlichen Rückseitenbeschichtung. Hier wird auf die kristalline n-dotierte Siliziumschicht 7, die eine Dicke von 200 µm aufweist, auf beiden Seiten mittels ALD bzw. dem ähnlich arbeitenden PECVD-Verfahren eine Tunnelpassivierungsschicht(z.B. Aluminiumoxidschicht) 6 bzw. 9 aufgetragen. Diese (Aluminiumoxid)schichten weisen eine Dicke von 0,1 bis 10 nm auf. Auf der Vorderseite der Heterosolarzelle folgt eine p-dotierte amorphe Siliziumschicht 4 mit einer Dicke von 1 bis 10 nm, wie eine ITO-Schicht 3, die eine Dicke von 80 nm aufweist. Auf der Vorderseite ist die Solarzelle mit Metallkontakten 2 versehen. Die Rückseite der Heterosolarzelle 1 bildet eine abschließende Aluminiumschicht 8. Zwischen der Aluminiumschicht 8 und der Aluminiumoxidschicht 9 ist eine amorphe n-dotierte
Siliziumschicht 10 eingeschoben. Diese weist eine Dicke von 1 bis 30 nm auf.

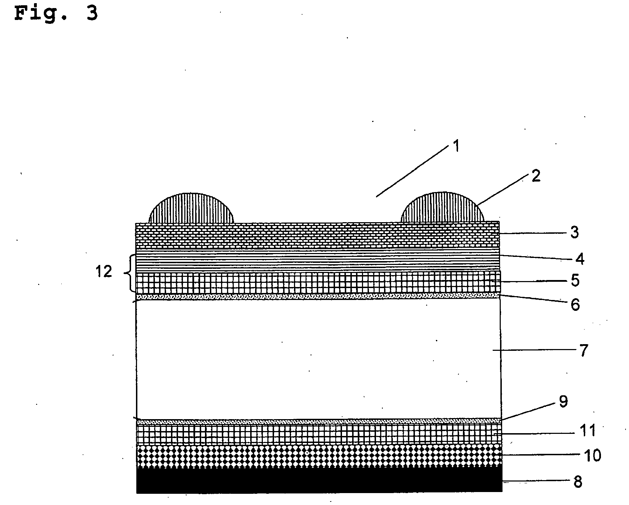

Figur 3 zeigt eine Heterosolarzelle 1 mit einer vorderseitigen Emitterschicht 12 und einer zusätzlichen Rückseitenbeschichtung, die eine weitere intrinsische Schicht 11 enthält. Diese Heterosolarzelle ist aus einer Aluminiumschicht 8 aufgebaut. Als nachste Schicht folgt eine 1 bis 30 nm dicke amorphe n-dotierte Siliziumschicht 10. Auf diese ist eine intrinsische amorphe Siliziumschicht 11 mit einer Dicke von bis 10 nm aufgetragen. Zwischen der n oder p-dotierten kristallinen Siliziumschicht 7 und der amorphen intrinsischen Siliziumschicht 11 ist eine Tunnelpassivierungsschicht 9 enthalten. Diese weist eine Dicke von 0,1 bis 10 nm auf. Auf der Vorderseite der 200 nm dicken kristallinen n-dotierten Siliziumschicht 7 ist eine weitere Tunnelpassivierungsschicht 6 mit einer Dicke von 0,1 bis 10 nm aufgetragen. Darauf folgt eine intrinsische amorphe Siliziumschicht 5 mit einer Schichtdicke von 1 bis 10 nm. Zwischen der ITO-Schicht 3, die eine Dicke von ca. 80 nm aufweist, und der intrinsischen amorphen Siliziumschicht 5 ist eine p-dotierte amorphe Siliziumschicht 4 mit einer Schichtdicke von 1 bis 10 nm aufgetragen. Auf der Vorderseite der Heterosolarzelle 1 sind Metallkontakte 2 angebracht.

### Ausführungsbeispiel 1

Die amorphen Siliziumschichten werden mittels Plasma-unterstützter chemischer Gasphasenabscheidung (PECVD) hergestellt. Die hierbei eingesetzte Generatorleistung und -frequenz beträgt 2 bis 200 W und 13,56 MHz bis zu 2 GHz. Die Gasflüsse liegen im Bereich von 1 bis 100 sccm für Silan SiH₄, 0 bis 100 sccm für Wasserstoff H₂, für die Dotierung mittels Diboran B₂H₆ und für Phosphin PH₃ (in 1-5 % H₂ gelöst) 1 bis 50 sccm. Die Temperatur des Substrates liegt zwischen 100 und 300 °C. Der vorherrschende Druck in der PECVD-Anlage während des Herstellungsprozesses der Heterosolarzelle liegt zwischen 10¹ und 10⁻⁵ mbar (abhängig von der eingesetzten Plasmaquelle). Der Basisdruck ist kleiner 10⁻⁵ mbar zu wählen. Der Elektrodenabstand, im Falle eines Parallelplattenreaktors, liegt zwischen 0,5 und 5 cm. Die Prozessdauer ergibt sich aus der Abscheiderate und der gewünschten Schichtdicke und liegt im Bereich 5 bis 60 Sekunden. Die Tunnelpassivierungsschicht (z.B. Al₂O₃) wird mittels Atomlagendeposition (ALD) oder ähnlich arbeitenden PECVD-Prozessen abgeschieden. Diese Aluminiumoxidschichten werden in zwei Zyklen hergestellt. Zyklus 1 umfasst die Deposition von radikalisierten Trimethylaluminium und Zyklus 2 die Oxidation der Schichten mit O₂. Das abgeschiedene Trimethylaluminium wird mittels einer Plasmaquelle, vergleichbar mit der bereits beschriebenen, die sich relativ weit entfernt vom Substrat befindet (5 bis 50 cm), radikalisiert. Die Substrattemperatur beträgt hierbei Raumtemperatur bis 350 °C.

## Patentansprüche

1. Heterosolarzelle (1) umfassend eine auf der vorderseitigen Oberfläche eines kristallinen, dotierten Silizium-Wafers (c-Si-Schicht) (7) angeordneten Emitter (12) aus einer amorphen, der c-Si-Schicht entgegengesetzt dotierten, Silizium-Schicht (a-Si-Schicht) (4) sowie einer darauf angeordneten ITO-Schicht (3) mit Vorderseitenkontakt (2) und einer auf der rückseitigen Oberfläche angeordneten Metallisierungsschicht (8), wobei mindestens zwischen der vorderseitigen Oberfläche der c-Si-Schicht (7) und der Emitter-Schicht (12) eine Tunnelpassivierungsschicht (6)
aufgebracht ist,
**dadurch gekennzeichnet, dass** die Tunnelpassivierungsschicht (6) Aluminiumoxid enthält.

2. Heterosolarzelle (1) gemäß Anspruch 1, **dadurch gekennzeichnet, dass** auf der vorderseitigen und rückseitigen Oberfläche eine Tunnelpassivierungsschicht (6, 9) aufgebracht ist.

3. Heterosolarzelle (1) gemäß einem der vorangegangenen Ansprüche, **dadurch gekennzeichnet, dass** die Dicke der Tunnelpassivierungsschicht (6, 9) so gewählt ist, dass ein quantenmechanischer Tunnelstrom fließt.

4. Heterosolarzelle (1) gemäß einem der vorhergehenden Ansprüche, **dadurch gekennzeichnet, dass** die Tunnelpassivierungsschicht (6,9) aus Aluminiumoxid besteht.

5. Heterosolarzelle (1) gemäß einem der vorhergehenden Ansprüche, **dadurch gekennzeichnet, dass** in der Tunnelpassivierungsschicht (6,9) Ionen, bevorzugt Caesium-Ionen, implantiert sind.

6. Heterosolarzelle (1) gemäß einem der vorhergehenden Ansprüche, **dadurch gekennzeichnet, dass** die Dicke der Tunnelpassivierungsschicht (6, 9) aus Aluminiumoxid zwischen 0,1 und 10 nm liegt.

7. Heterosolarzelle (1) gemäß einem der vorangegangenen Ansprüche, **dadurch gekennzeichnet, dass** die Emitter-Schicht (12) aus einer, der c-Si-Schicht entgegengesetzt dotierten, a-Si-Schicht (4) und einer intrinsischen Silizium-Schicht (i-Si-Schicht) (5) besteht.

8. Heterosolarzelle (1) gemäß Anspruch 7, **dadurch gekennzeichnet, dass** die Dicke der a-Si-Schicht (4) zwischen 1 und 10 nm liegt und/oder die Dicke der i-Si-Schicht (5) zwischen 1 und 10 nm liegt.

9. Heterosolarzelle (1) gemäß einem der vorangegangenen Ansprüche, **dadurch gekennzeichnet, dass** zwischen der rückseitigen Oberfläche und der Metallisierungsschicht (8) eine, der c-Si-Schicht gleich dotierte, a-Si-Schicht (10) aufgebracht ist.

10. Heterosolarzelle (1) gemäß Anspruch 9, **dadurch gekennzeichnet, dass** die Dicke der a-Si-Schicht (10) zwischen 1 und 30 nm liegt.

11. Heterosolarzelle (1) gemäß einem der Ansprüche 9 oder 10, **dadurch gekennzeichnet, dass** auf der vorderseitigen und rückseitigen Oberfläche eine Tunnelpassivierungsschicht (6, 9) aufgebracht ist und zwischen der auf der rückseitigen Oberfläche aufgebrachten Tunnelpassivierungsschicht (9) und der aufgebrachten, der c-Si-Schicht gleich dotierten, a-Si-Schicht (10) eine intrinsische Silizium-Schicht (i-Si-Schicht) (11) aufgebracht ist.

12. Heterosolarzelle (1) gemäß Anspruch 11, **dadurch gekennzeichnet, dass** die Dicke der i-Si-Schicht (11) zwischen 1 und 10 nm liegt.

13. Heterosolarzelle (1) gemäß einem der vorangegangenen Ansprüche, **dadurch gekennzeichnet, dass** die c-Si-Schicht (7) n- oder p-dotiert ist und/oder die Dicke der, c-Si-Schicht (7) zwischen 20 und 2000 µm liegt.

14. Heterosolarzelle (1) gemäß einem der Ansprüche 7 bis 13, **dadurch gekennzeichnet, dass** die in der Emitter-Schicht (12) enthaltene, der c-Si-Schicht entgegengesetzt dotierte, a-Si-Schicht (4) n- oder p-dotiert ist.

15. Heterosolarzelle (1) gemäß einem der Ansprüche 9 bis 14, **dadurch gekennzeichnet, dass** die zwischen der rückseitigen Oberfläche und der Metallisierungsschicht (8) aufgebrachte, der c-Si-Schicht gleich dotierte, a-Si-Schicht (10) n- oder p-dotiert ist.

16. Verfahren zur Herstellung einer Heterosolarzelle (1) nach mindestens einem der Ansprüche 1 bis 15, **dadurch gekennzeichnet, dass** die mindestens eine Tunnelpassivierungsschicht (6,9) mittels Atomlagendeposition oder ähnlich arbeitender PECVD-Technologie abgeschieden wird, wobei als Tunnelpassivierungsschicht (6,9) eine Aluminiumoxid-Schicht, die Cs⁺-Ionen enthalten kann, abgeschieden wird.

## Claims

1. Hetero solar cell (1) comprising an emitter (12) arranged on the front surface of a crystalline, doped silicon wafer (c-Si layer) (7), said emitter being made from an amorphous silicon layer (a-Si layer) (4) which is doped oppositely to the c-Si layer, as well as an ITO layer (3) arranged thereon having front side contact (2) and a metallisation layer (8) arranged on the rear surface, wherein a tunnel passivation layer (6) is applied at least between the front surface of the c-Si layer (7) and the emitter layer (12),
**characterised in that**
the tunnel passivation layer (6) contains aluminium oxide.

2. Hetero solar cell (1) according to claim 1, **characterised in that** a tunnel passivation layer (6, 9) is applied to the front and rear surface.

3. Hetero solar cell (1) according to one of the preceding claims, **characterised in that** the thickness of the tunnel passivation layer (6, 9) is selected in such a way that a quantum mechanical tunnel current circulates.

4. Hetero solar cell (1) according to one of the preceding claims, **characterised in that** the tunnel passivation layer (6, 9) consists of aluminium oxide.

5. Hetero solar cell (1) according to one of the preceding claims, **characterised in that** ions, preferably caesium ions, are implanted in the tunnel passivation layer (6, 9).

6. Hetero solar cell (1) according to one of the preceding claims, **characterised in that** the thickness of the tunnel passivation layer (6, 9) made from aluminium oxide is between 0.1 and 10nm.

7. Hetero solar cell (1) according to one of the preceding claims, **characterised in that** the emitter layer (12) consists of an a-Si layer (4) which is doped oppositely to the c-Si layer and an intrinsic silicon layer (i-Si layer) (5).

8. Hetero solar cell (1) according to claim 7, **characterised in that** the thickness of the α-Si layer (4) is between 1 and 10nm and/or the thickness of the i-Si layer (5) is between 1 and 10nm.

9. Hetero solar cell (1) according to one of the preceding claims, **characterised in that** an a-Si layer (10) which is doped the same as the c-Si layer is applied between the rear surface and the metallisation layer (8).

10. Hetero solar cell (1) according to claim 9, **characterised in that** the thickness of the α-Si layer (10) is between 1 and 30nm.

11. Hetero solar cell (1) according to one of claims 9 or 10, **characterised in that** a tunnel passivation layer (6, 9) is applied to the front and rear surfaces and an intrinsic silicon layer (i-Si layer) (11) is applied between the tunnel passivation layer (9) applied to the rear surface and the applied a-Si layer (10) which is doped the same as the c-Si layer.

12. Hetero solar cell (1) according to claim 11, **characterised in that** the thickness of the i-Si layer (11) is between 1 and 10mn.

13. Hetero solar cell (1) according to one of the preceding claims, **characterised in that** the c-Si layer (7) is n- or p-doped and/or the thickness of the c-Si layer (7) is between 20 and 2000µm.

14. Hetero solar cell (1) according to one of claims 7 to 13, **characterised in that** the a-Si layer (4) which is doped oppositely to the c-Si layer and contained in the emitter layer (12) is n- or p-doped.

15. Hetero solar cell (1) according to one of claims 9 to 14, **characterised in that** the a-Si layer (10) which is doped the same as the c-Si layer and applied between the rear surface and the metallisation layer (8) is n- or p-doped.

16. Method for the production of a hetero solar cell (1) according to at least one of claims 1 to 15, **characterised in that** the at least one tunnel passivation layer (6, 9) is deposited by means of atomic layer deposition or similarly functioning PECVD technology, wherein an aluminium oxide layer, which can contain Cs⁺ ions, is deposited as the tunnel passivation layer (6, 9).

## Revendications

1. Cellule solaire à hétérojonction (1), comprenant un émetteur (12), disposé sur la surface côté avant d'une tranche de silicium dopée, cristalline (couche c-Si) (7), constitué d'une couche de silicium amorphe (couche a-Si) (4), à dopage opposé à celui de la couche c-Si, ainsi que d'une couche ITO (3), disposée par-dessus, ayant un contact face avant (2), et d'une couche de métallisation (8), disposée sur la surface côté arrière, une couche de passivation tunnel (6) étant appliquée au moins entre la surface côté avant de la couche c-Si (7) et la couche formant émetteur (12), **caractérisée en ce que** la couche de passivation tunnel (6) contient de l'oxyde d'aluminium.

2. Cellule solaire à hétérojonction (1) selon la revendication 1, **caractérisée en ce qu'**une couche de passivation tunnel (6, 9) est appliquée sur la surface côté avant et sur la surface côté arrière.

3. Cellule solaire à hétérojonction (1) selon l'une des revendications précédentes, **caractérisée en ce que** l'épaisseur de la couche de passivation tunnel (6, 9) est choisie de façon que s'écoule un courant tunnel en mécanique quantique.

4. Cellule solaire à hétérojonction (1) selon l'une des revendications précédentes, **caractérisée en ce que** la couche de passivation tunnel (6, 9) est constituée d'oxyde d'aluminium.

5. Cellule solaire à hétérojonction (1) selon l'une des revendications précédentes, **caractérisée en ce que** des ions, de préférence des ions césium, sont implantés dans la couche de passivation tunnel (6, 9).

6. Cellule solaire à hétérojonction (1) selon l'une des revendications précédentes, **caractérisée en ce que** l'épaisseur de la couche de passivation tunnel (6, 9) en oxyde d'aluminium est comprise entre 0,1 et 10 nm.

7. Cellule solaire à hétérojonction (1) selon l'une des revendications précédentes, **caractérisée en ce que** la couche formant émetteur (12) est constituée d'une couche a-Si (4) à dopage opposé à celui la couche c-Si, et d'une couche de silicium intrinsèque (couche i-Si) (5).

8. Cellule solaire à hétérojonction (1) selon la revendication 7, **caractérisée en ce que** l'épaisseur de la couche a-Si (4) est comprise entre 1 et 10 nm, et/ou que l'épaisseur de la couche i-Si (5) est comprise entre 1 et 10 nm.

9. Cellule solaire à hétérojonction (1) selon l'une des revendications précédentes, **caractérisée en ce qu'**entre la surface côté arrière et la couche de métallisation (8) est appliquée une couche a-Si (10), à dopage identique à celui de la couche c-Si.

10. Cellule solaire à hétérojonction (1) selon la revendication 9, **caractérisée en ce que** l'épaisseur de la couche a-Si (10) est comprise entre 1 et 30 nm.

11. Cellule solaire à hétérojonction (1) selon l'une des revendications 9 ou 10, **caractérisée en ce que** la surface côté avant et sur la surface côté arrière est appliquée une couche de passivation tunnel (6, 9), et entre la couche de passivation tunnel (9) appliquée sur la surface côté arrière et la couche a-Si (10) appliquée, à dopage identique à celui de la couche c-Si, est appliquée une couche de silicium intrinsèque (couche i-Si) (11).

12. Cellule solaire à hétérojonction (1) selon la revendication 11, **caractérisée en ce que** l'épaisseur de la couche i-Si (11) est comprise entre 1 et 10 nm.

13. Cellule solaire à hétérojonction (1) selon l'une des revendications précédentes, **caractérisée en ce que** la couche c-Si (7) est dopée n ou p, et/ou que l'épaisseur de la couche c-Si (7) est comprise entre 20 et 2000 µm.

14. Cellule solaire à hétérojonction (1) selon l'une des revendications 7 à 13, **caractérisée en ce que** la couche a-Si (4), contenue dans la couche formant émetteur (12), à dopage opposé à celui de la couche c-Si, est dopée n ou p.

15. Cellule solaire à hétérojonction (1) selon l'une des revendications 9 à 14, **caractérisée en ce que** la couche a-Si (10) appliquée entre la surface côté arrière et la couche de métallisation (8), à dopage identique à celui de la couche c-Si, est dopée n ou p.

16. Procédé de fabrication d'une cellule solaire à hétérojonction (1) selon au moins l'une des revendications 1 à 15, **caractérisé en ce que** la ou les couches de passivation tunnel (6, 9) sont déposées par dépôt de couches atomiques ou par une technologie PECVD fonctionnant d'une manière analogue, auquel cas on dépose en tant que couche de passivation tunnel (6, 9) une couche d'oxyde d'aluminium qui peut contenir des ions Cs⁺.
